Europäisches Patentamt

European Patent Office

Office européen des brevets

(19)

(11) Numéro de publication: **0 204 609**
**B1**

# (12) FASCICULE DE BREVET EUROPEEN

(45) Date de publication du fascicule du brevet:
07.02.90

(21) Numéro de dépôt: 86401100.2

(22) Date de dépôt: 26.05.86

(51) Int. Cl.⁴: **B08B 3/12, H05K 3/26**

(54) **Appareil de nettoyage pour composants électroniques et/ou pour pièces mécaniques de précision.**

(30) Priorité: 28.05.85 FR 8507979

(43) Date de publication de la demande:
10.12.86 Bulletin 86/50

(45) Mention de la délivrance du brevet:
07.02.90 Bulletin 90/6

(84) Etats contractants désignés:
AT BE CH DE GB IT LI LU NL SE

(56) Documents cités:
EP-A- 0 104 633
DE-B- 1 088 781
FR-A- 2 462 207

(73) Titulaire: OUTILLAGES SCIENTIFIQUES ET DE
LABORATOIRES O.S.L., Z.I. Secteur Bleu N83,
F-06510 Carros Industries(FR)

(72) Inventeur: Sauvan, Gérard, Les Jardins de la Palombière
Chemin du Val Fleuri, F-06800 Cagnes sur Mer(FR)

(74) Mandataire: Clanet, Denis et al, Cabinet Beau de
Loménie 55, rue d'Amsterdam, F-75008 Paris(FR)

ACTORUM AG

## Description

La présente invention concerne un appareil de nettoyage notamment pour composants électroniques.

Ce type d'appareil est utilisé dans l'industrie électronique en particulier en aval des appareils de soudage à la vague où l'on effectue le soudage des composants électroniques sur des cartes de circuits imprimés (EP-A 0 104 633).

Pour la bonne réalisation des soudures dans l'appareil de soudage, les cartes sont tout d'abord enduites de flux puis traversent un étage de préchauffage où les composants volatiles du flux s'évaporent et où la carte est préchauffée, les cartes passent ensuite le long d'une vague stationnaire de soudure liquide en léchant cette dernière par leur face inférieure, puis les cartes quittent l'appareil de soudage.

Elles portent à ce moment là de nombreuses traces de restes de flux plus ou moins décomposés qu'il convient de supprimer à l'aide d'un appareil de nettoyage.

De manière typique, on réalise le nettoyage par aspersion d'un solvant tant par le dessus que par le dessous des cartes entraînées par un convoyeur qui traverse l'enceinte de l'appareil de nettoyage.

Il y a bien entendu plusieurs étages d'aspersion pour les étapes successives de nettoyage, typiquement au nombre de quatre : prélavage, lavage, rinçage et rinçage final.

Le solvant utilisé dans l'étage d'aspersion de rinçage final est puisé par une pompe de rinçage final dans un réservoir de solvant purifié. Après aspersion, il s'égoutte dans un second réservoir d'où il est puisé par une pompe de rinçage et renvoyé dans les rampes d'aspersion de rinçage. Le solvant utilisé dans l'étage de rinçage s'égoutte dans le second réservoir. Une partie de ce solvant s'écoule via un trop-plein dans un troisième réservoir commun à l'étage de lavage et l'étage de prélavage. Il est puisé dans ce réservoir par une pompe qui le refoule vers les rampes d'aspersion de lavage et de prélavage. Après aspersion, le solvant, de plus en plus chargé en impuretés, s'écoule vers le troisième réservoir.

Une partie du solvant s'écoule par trop-plein de ce troisième réservoir vers un réservoir d'évacuation. Compte tenu du prix des solvants utilisés, ils sont purifiés par une installation de distillation annexe qui puise le solvant chargé en impuretés dans le réseroir d'évacuation puis restitue du solvant purifié dans le réservoir de l'étage de rinçage final.

Pour éviter que la concentration en impuretés n'augmente fortement dans les étages successifs, on doit opérer avec de grandes quantités de solvant qui sont constamment recyclées et dont une faible partie est progressivement transférée jusqu'au réservoir d'évacuation.

On sait également concevoir des installations de nettoyage par ultra-sons mais qui mettent généralement en oeuvre des bains de solvant statiques dans lesquels on plonge un lot de cartes de circuits imprimés pendant un laps de temps prédéterminé, et ceci dans plusieurs bains successivement. Ce type d'installation se prête mal à l'automatisation et surtout au convoyage en continu des cartes de circuits imprimés depuis l'entrée jussqu'à la sortie de l'appareil de nettoyage.

Ce sont en outre les installation où le nettoyage s'effectue exclusivement au moyen d'ultra-sons et si l'on désire pour diverses raison assurer un nettoyage par aspersion de certaines séries de cartes, on doit prévoir une installation spécifique à cet effet, d'où duplication d'appareillage, augmentation de l'encombrement, du coût, de la maintenance, etc...

Dans le but de pallier ces inconvénients, la présente invention propose un appareil de nettoyage pour cartes de circuits imprimés, comprenant une enceinte traversée par un convoyeur entraînant les cartes suivant un trajet continu, au moins un groupe de nettoyage par solvant agencé de manière à assurer une aspersion de solvant par le dessus et le dessous des cartes entraînées le long dudit trajet, au moins un réservoir à solvant situé en partie basse de l'enceinte et destiné à recueillir le solvant qui s'écoule après l'aspersion, et un bac, destiné à recevoir du solvant, et traversé par un tronçon dudit trajet caractérisé en ce que ledit bac consiste en un bac de faible profondeur de rétention de solvant agencé dans ladite enceinte, parallèlement à un tronçon horizontal du trajet et à faible distance au-dessous de celui-ci et au-dessus dudit réservoir, et équipe de générateurs ultra-sonores afin de constituer ainsi un groupe de nettoyage par ultra-sons, ledit bac de rétention comportant au moins un conduit d'évacuation vers ledit réservoir et commandé par une vanne et un moyen d'évacuation le long d'un flanc du bac du côté de l'entrée des cartes, et en ce qu'il comprend un dispositif de commande cestiné à la commande sélective dudit groupe de nettoyage par aspersion, dudit groupe de nettoyage par ultrasons et de ladite vanne, de manière à déterminer un premier mode de fonctionnement en nettoyage par aspersion dans lequel ledit groupe de nettoyage par aspersion est en fonctionnement, ledit groupe de nettoyage par ultrasons est à l'arrêt et ladite vanne est ouverte pour permettre un écoulement du solvant qui s'égoutte en direction dudit réservoir et un second mode de fonctionnement en nettoyage par ultrasons dans lequel ladite vanne est fermée, ledit groupe de nettoyage par ultrasons est en fonctionnement, dont il résulte que le bac est rempli d'une nappe de solvant de faible épaisseur dans laquelle sont immergées les cartes entraînées le long dudit trajet et que la nappe de solvant s'écoule dans ledit bac en sens contraire au sens de déplacement des cartes de circuit imprimé.

Les détails et avantages de l'invention seront mieux compris à l'aide de la description qui va suivre en se rapportant aux dessins annexés dans lesquels ;

la figure 1 est une vue en coupe longitudinale schématique d'un appareil selon l'invention en fonctionnement de nettoyage par aspersion,

la figure 2 est une vue similaire à celle de la figure 1, illustrant le fonctionnement de l'appareil en nettoyage par ultra-sons, et

la figure 3 est une vue détaillée de la réalisation des générateurs ultra-sonores de l'appareil des figures 1 et 2.

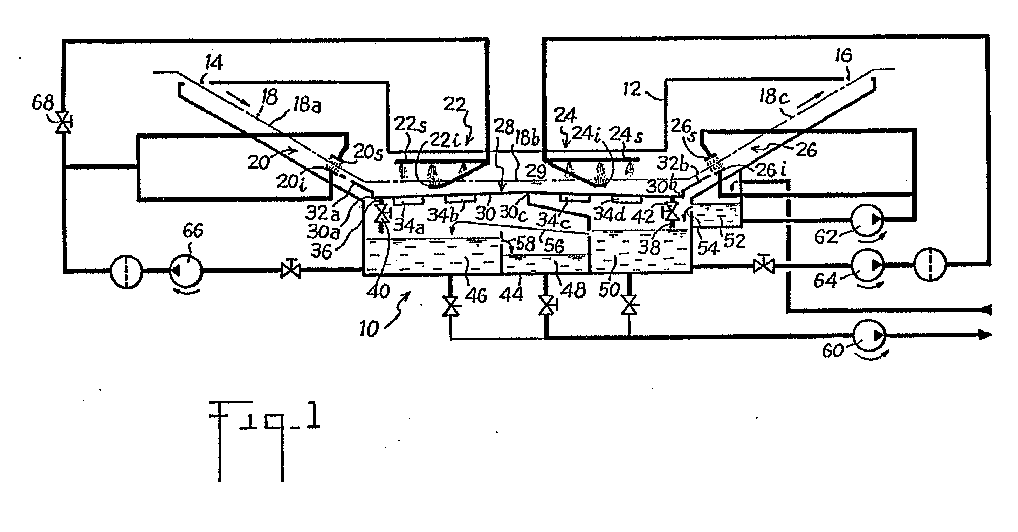

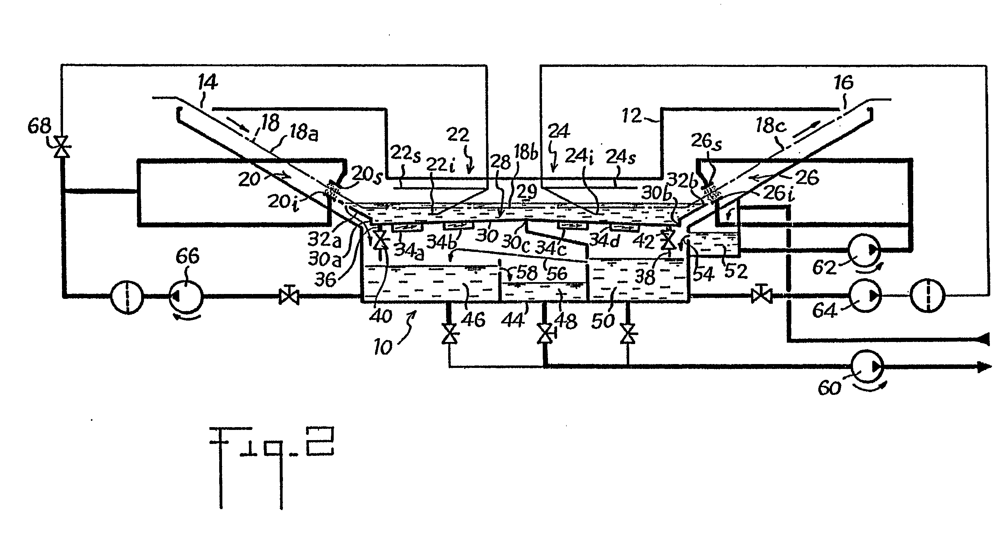

l'appareil, désigné dans son ensemble par la référence 10 aux figures 1 et 2, comprend une enceinte 12, sensiblement fermée, qui comporte une fenêtre d'entrée 14 et une fenêtre de sortie 16. Un convoyeur qui n'a pas été repreésenté à la figure pour des raisons de clarté traverse l'enceinte 12 depuis la fenêtre d'entrée jusqu'à la fenêtre de sortie de manière à définir un trajet 18 illustré en traits mixtes, le long duquel se déplacent des cartes de circuits imprimés provenant d'une machine de soudage, comme cela a été indiqué en introduction, les cartes arrivant par l'extrémité gauche de l'appareil de nettoyage si l'on considère les figures.

L'appareil 10 comprend des groupes de nettoyage par aspersion de solvant, dans le cas présent au nombre de quatre, à savoir un groupe de prélavage 20, un groupe de lavage 22, un groupe de rinçage 24 et un groupe de rinçage final 26.

Le trajet 18 comporte un premier tronçon en pente descendante 18a à partir de la fenêtre d'entrée 14 et le groupe de prélevage 20 est formé de deux rampes d'aspersion 20i et 20s situées respectivement au-dessous et au-dessus du tronçon descendant 18a de manière à assurer une aspersion de solvant tant par le dessous que par le dessus des cartes en déplacement le long du trajet 18.

Le trajet 18 se poursuit par un tronçon horizontal 18b, et les deux groupes de lavage 22 et de rinçage 24 sont installés l'un derrieère l'autre le long de ce tronçon 18b, chaque groupe étant formé de rampes d'aspersion 22i, 22s, 24i, 24s situées au-dessus et au-dessous du trajet 18 des cartes.

Enfin, le trajet 18 se termine par un tronçon à pente montante 18c jusqu'à la fenêtre de sortie 16, et le groupe de rinçage final 26 est formé, lui aussi, de deux rampes 26i et 26s au-dessus et au-dessous du tronçon de trajet 18c.

A contre distance au-dessous du trajet horizontal 18b du trajet s'étend un bac 28 de faible profondeur qui est destiné, selon les conditions de fonctionnement qui seront décrites par la suite, à la rétention d'une certaine quantité de solvant. Le bac 28 comporte un fond 30 sensiblement horizontal et parallèle au tronçon du trajet 18b, et des flancs 32a, 32b de telle manière que les cartes se déplaçant dans ce tronçon puissent être totalement immergées dans la nappe de solvant de faible épaisseur retenue dans le bac 28.

Sous le fond 30 du bac 28 sont agencés un certain nombre de générateurs ultra-sonores 34a, 34b, etc... dont la structure seradécrite ultérieurement. Le bac et les générateurs constituent un groupe de nettoyage par ultra-sons 29.

Le fond du bac 30 présente de préférence un profil à deux pentes opposées depuis une zone centrale 30c, située entre les groupes d'aspersion de lavage 22 et de rinçage 24, jusqu'à deux zones extrêmes 30a et 30b où le fond est pourvu de conduits d'évacuation 36 et 38 équipés de vannes 40 et 42.

Entre le fond 30 du bac 28 et la base 44 de l'enceinte 12 sont définis plusieurs réservoirs à solvant, séparés par des cloisons verticales.

On distingue ainsi de la gauche vers la droite en considérant les figures 1 et 2, un réservoir de lavage 46, un réservoir d'évacuation 48 et un réservoir de rinçage 50. Un réservoir de solvant pur 52 est enfin agencé à l'extrémité droite de l'appareil et à un niveau supérieur aux autres réservoirs.

Des déversements par trop-plein sont prévus entre les divers réservoirs de la manière suivante :
- un trop-plein 54 du réservoir de solvant pur vers le réservoir de rinçage,
- un trop-plein 56 du réservoir de rinçage vers le réservoir de lavage,
- un trop-plein 58 du réservoir de lavage vers le réservoir d'évacuation.

Comme on le comprendra par la suite, le réservoir d'évacuation 48 recueille le solvant le plus chargé en impuretés et une pompe d'évacuation 60 puise le solvant dans ce réservoir pour le refouler vers un distilleur, bien connu en soi, qui n'a pas été représenté. Le solvant pur revient du distilleur vers le réservoir de solvant pur 52.

Les autres détails de structure de l'appareil seront évoqués au fur et à mesure de la description des deux modes de fonctionnement de l'appareil, successivement à l'aide des figures 1 et 2.

Le fonctionnement en nettoyage par aspersion illustré à la figure 1 met en jeu des quatre groupes de nettoyage par aspersion.

Une pompe de rinçage final 62 puise du solvant pur dans le réservoir 52 pour le refouler dans les rampes du groupe de rinçage final 26. Le solvant qui s'égoutte est recueilli dans le bac 28 en s'écoulant le long du flanc 32b. Dans ce mode de fonctionnement, la vanne 42 est ouverte et le solvant s'écoule donc par le conduit 38 vers le réservoir de rinçage 50. Il est puisé dans ce réservoir par une pompe de rinçage 64 qui le refoule dans les rampes du groupe de rinçage 24.

Le solvant qui s'égoutte est recueilli dans le bac 28 et sécoule le long du fond 30 en pente jusqu'au conduit 38 puis au réservoir 50. La contenance du réservoir 50 est calculée de manière à ce que la concentration en impuretés, compte tenu du débit de solvant pur qui revient du distilleur, reste dans une plage faible.

Le trop-plein 56 transfère donc vers le réservoir de lavage 46 un débit de solvant sensiblement égal au débit de solvant pur et contenant une faible concentration d'impuretés.

Une pompe de lavage 66 puise le solvant dans le réservoir 46 pour le refouler dans les rampes des deux groupes de prélavage 20 et de lavage 22. Le solvant qui s'égoutte des rampes du groupe de lavage 22 tombe dans le bac et s'y écoule le long du fond 30 jusqu'au conduit 36. La vanne 40 est également ouverte et le solvant est recueilli dans le réservoir 46.

Les rampes 20i, 20s du groupe de prélavage 20 sont disposées à une certaine distance du flanc 32a de sorte que le solvant qui s'égoutte s'écoule directement le long de la paroi de l'enceinte 12 vers le réservoir 46 sans transiter par le bac 28.

Dans tout ce qui précède, on comprend bien entendu que les générateurs ultra-sonores restent inactifs.

Le fonctionnement en nettoyage par ultra-sons, illustré à la figure 2, met en jeu le groupe de nettoyage par ultra-sons, ainsi que deux des groupes d'aspersion, le groupe de prélavage 20 et le groupe de rinçage final 26.

Dans ce cas, les vannes 40 et 42 sont fermées, de sorte que le bac 28 se remplit d'une nappe de solvant et les cartes de circuit imprimé sont immergées dans la nappe de solvant tout au long du tronçon 18b du trajet 18.

Le groupe de lavage 22 et le groupe de rinçage 24 sont à l'arrêt. Ceci est déterminé par l'arrêt de la pompe de rinçage 64 et par l'isolement du groupe de lavage à l'aide d'une vanne d'isolement 68.

Le solvant pur puisé dans le réservoir 52 et pulvérisé par les rampes d'aspersion 26i et 26s du groupe de rinçage final s'égoutte vers le bac en s'écoulant le long du flanc 32b. On ménage une évacuation permanente du solvant à l'extrémité opposée du bac grâce au fait que le flanc 32a a une hauteur inférieure à celle du flanc 32b. Ainsi, la nappe de solvant s'écoule le long du bac depuis la zone de rinçage final vers la zone de prélavage, donc en sens contraire au sens de déplacement des cartes le long du trajet 18, en se chargeant progressivement d'impuretés qui se détachent sous l'effet des ultra-sons produits par les générateurs 34a, b, c, etc...

Dans ce mode de fonctionnement, les transferts par trop-plein s'effectuent entre les différents réservoirs comme précédemment.

On remarquera que la faible distance entre le fond 30 du bac 28 et le tronçon de trajet 18b permet d'une part un excellente action des générateurs ultra-sonores 34 et d'autre part de limiter le volume de solvant contenu dans le bac. Ainsi, le débit de solvant pur admis via les rampes de rinçage final 26i, 26s et le flanc 32b permet d'établir une circulation et un renouvellement efficaces de la nappe de solvant dans le bac, ce qui limite la concentration maximale en impuretés à l'autre extrémité du bac à une valeur admissible.

On comprendra que l'appareil comporte également un dispositif de commande, non représenté, comprenant tous les circuits nécessaires pour la commande sélective des divers groupes en vue du passage d'un mode de fonctionnement à l'autre.

Le dispositif de commande détermine également la mise en route et l'arrêt des pompes de l'appareil ainsi que l'ouverture et la fermeture des vannes dans le sens indiqué au cours de la description.

Ainsi, l'invention permet donc d'assurer, à l'aide de la même machine, un nettoyage en continu de cartes de circuits imprimés soit par aspersion, soit par ultra-sons, ou encore par une combinaison simultanée de deux modes.

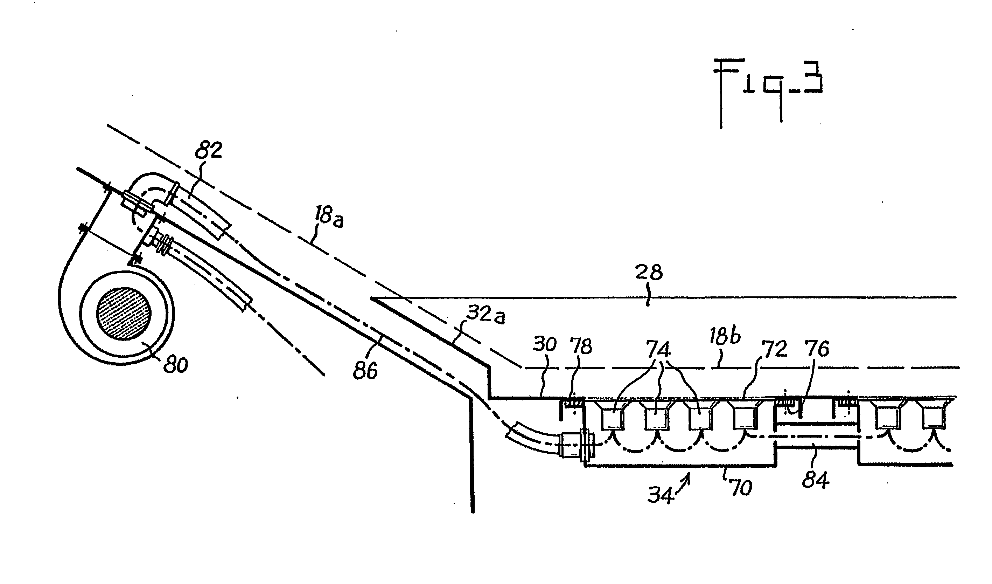

Pour tenir compte de la présence dans l'enceinte d'une atmosphère constamment saturée en vapeurs de solvant, ce qui risquerait d'endommager les transducteurs des générateurs ultra-sonores, on a prévu de réaliser ces générateurs comme illustré à la figure 3.

Chaque générateur 34 comprend un boîtier sensiblement parallèlépipédique 70 muni d'un couvercle plan 72 sur lequel sont collés les transducteurs 74, le couvercle étant fixé sur un rebord 76 du boîtier avec interposition d'un joint d'étanchéité 78. Les boîtiers sont ensuite fixés au-dessous du fond 30 du bac 28, ce fond comportant des ouvertures correspondantes de manière à ce que le solvant soit directement en contact avec la face externe du couvercle 72.

Les boîtiers sont maintenus constamment sous pression gazeuse, à l'aide d'air sec, d'un gaz neutre, ou d'un mélange de gaz neutres, au moyen d'un ventilateur 80. Le conduit de refoulement 82 du ventilateur traverse de manière étanche l'enceinte 12 puis la paroi du boîtier 70. Les boîtiers des autres générateurs sont reliés successivement en série par des conduits de transfert 84.

De cette manière, on maintient les transducteurs à l'abri des vapeurs saturées de solvant sans avoir à apporter un soin particulier à la réalisation de l'étanchéité des boîtiers. On évite également les difficultés à long terme qui résultent de pertes d'étanchéité du boîtier malgré le soin apporté lors de la fabrication du boîtier.

Selon l'invention, on évite également une réalisation soignée de l'étanchéité à la traversée du câble d'alimentation électrique 86 des transducteurs par le fait que l'on dispose ce câble dans le conduit 82 de mise en pression gazeuse lui-même, puis d'un boîtier jusqu'au suivant via les conduits 84.

Etant donné que le débit au refoulement du ventilateur est virtuellement nul, celui-ci sera donc de très faibles dimensions et consommera une faible puissance.

L'appareil peut naturellement être utilisé au nettoyage d'éléments différents des cartes de circuits imprimés évoquées au cours de la description, par exemple des pièces mécaniques de précision, qu'elles soient associées ou non à des ensembles électroniques.

Enfin, parmi les solvants possibles, on mentionnera l'eau. la purification de cette eau pourra se faire par toute installation de régénération ou purification classique, en lieu et place de l'installation de distillation évoquée.

## Revendications

1. Appareil de nettoyage (10) notamment pour cartes de circuits imprimés, comprenant une enceinte (12) traversée par un convoyeur entraînant les cartes suivant un trajet (18) continu, au moins un groupe (22) de nettoyage par solvant agencé de manière à assurer une aspersion de solvant par le dessus et le dessous des cartes entraînées le long dudit trajet, au moins un réservoir à solvant situé en partie basse de l'enceinte et destiné à recueillir le solvant qui s'écoule après aspersion, et un bac, destiné à recevoir du solvant, et traversé par un tronçon dudit trajet caractérisé en ce que ledit bac consiste en un bac (28) de faible profondeur de rétention de solvant agencé dans ladite enceinte, parallèlement à un tronçon horizontal (18b) du trajet et à faible distance au-dessous de celui-ci et au-dessus dudit réservoir, et équipé de générateurs ultra-sonores (34) afin de constituer ainsi un groupe de nettoyge par ultra-sons (29), ledit bac de rétention (28) comportant au moins un conduit d'évacuation (36) vers ledit réservoir et commandé par une vanne (40) et un moyen d'évacuation le long d'un flanc du bac du côté de l'entrée des cartes, et en ce qu'il comprend un dispositif de commande destiné à la commande sélective dudit groupe de nettoyge par aspersion, dudit groupe de nettoyge par ultrasons et de ladite vanne; de manière à déterminer un premier mode de fonctionnement en nettoyge par aspersion dans lequel ledit groupe de nettoyge par aspersion est en fonctionnement, ledit groupe de nettoyge par ultrasons est à l'arrêt et ladite vanne est ouverte pour permettre un écoulement du solvant qui s'égoutte en direction dudit réservoir et un second mode de fonctionnement en nettoyge par ultrasons dans lequel ladite vanne est fermée, ledit groupe de nettoyage par ultrasons est en fonctionnement, dont il résulte que le bac est rempli d'une nappe de solvant de faible épaisseur dans laquelle sont immergées les cartes entraînées le long dudit trajet et que la nappe de solvant s'écoule dans ledit bac en sens contraire au sens de déplacement des cartes de circuit imprimé.

2. Appareil selon la revendication 1, caractérisé en ce qu'il comprend au moins deux groupes de nettoyage par aspersion (22, 26), chacun étant composé de rampes d'aspersion situées au-dessous et au-dessus(22i, 22s, 26i, 26s) dudit trajet (18), un des groupes (22) étant situé au-dessus du bac (28), et l'autre (26) étant situé en dehors de l'emprise du bac (28), ledit fond du bac comportant deux conduits d'évacuation (36, 38) équipé de vannes (40, 42) débouchant dans deux réservoirs de solvant (46, 50).

3. Appareil selon la revendication 2, caractérisé en ce qu'il comprend au moins trois groupes de nettoyage par aspersion (22, 24, 26) dont deux (22, 24) sont situés au-dessus du bac (28) et le troisième (26) en dehors du bac, le fond du bac présentant un profil à deux pentes opposées depuis une zone centrale située entre les deux premiers groupes et les conduits d'évacuation (36, 38) sont situés aux deux extrémités du bac et communiquent avec deux réservoirs de solvant respectifs (46, 50).

4. Appareil selon la revendication 3, caractérisé en ce que le troisième groupe d'aspersion (26) est un groupe de rinçage final alimenté en solvant pur et situé de manière immédiatement adjacente à un flanc (32b) du bac (28) du côté de la sortie des cartes, de telle sorte que le solvant pulvérisé retombe dans le bac.

5. Appareil selon l'une quelconque des revendications 1 à 4, caractérisé en ce que ledit groupe de nettoyage par ultra-sons (2a) comporte des transducteurs ultra-sonores (74) montés dans des boîtiers (70, 72) fermés, lesdits boîtiers étant fixés sous le fond (30) du bac (28).

6. Appareil selon la revendication 5, caractérisé en ce qu'il comporte un ventilateur (80) de mise en pression desdits boîtiers (70, 72) à l'aide d'air, de gaz neutre ou mélange de gaz neutres.

7. Appareil selon la revendication 6, caractérisé en ce que la liaison entre le ventilateur (80) et les boîtiers s'effectue via un conduit de refoulement (82) entre le ventilateur et un premier boîtier, puis entre les boîtiers successifs via des conduits de transfert (84).

8. Appareil selon la revendication 7, caractérisé en ce que le câble d'alimentation électrique (86) des transducteurs (74) est disposé dans lesdits conduits de refoulement (82) et de transfert (84).

9. Appareil selon l'une quelconque des revendications 1 à 8, caractérisé en ce que le flanc (32a) du bac (28) du côté de l'entrée a une hauteur inférieure à l'autre flanc (32b) du côté de la sortie.

10. Appareil selon l'une quelconque des revendications 2 à 9, caractérisé en ce que ledit trajet (18) présente un tronçon descendant (18a) depuis une fenêtre d'entrée (14) de l'enceinte (12) jusqu'audit tronçon horizontal (18b), ainsi qu'un tronçon ascendant (18c) depuis le tronçon horizontal (18b) jusqu'à une fenêtre de sortie (16) de l'enceinte (12).

11. Appareil selon la revendication 4, caractérisé en ce qu'il comporte en outre un groupe d'aspersion de prélavage (20) situé en avant et à écartement du flanc (32a) voisin du bac (28), de telle manière que le solvant pulvérisé retombe dans le fond de l'enceinte.

## Claims

1. Cleaning apparatus (10) particularly for cleaning printed circuit boards, of the type comprising an enclosure (12) through which passes a conveyor conveying the boards along a continuous path (18), at least one cleaning unit (22), using solvent and so arranged as to spray the solvent over and under the boards carried along said path, at least one solvent reservoir situated at the lower part of said enclosure and designed to receive the solvent dripping after the spraying operation and a tank, designed to receive the solvent, and through which passes a portion of said path, characterized in that said tank consists of a low depth solvent storing tank (28) arranged in said enclosure, in parallel relationship with respect to a horizontal portion (18b) of said path and at a short distance below said horizontal portion and above said reservoir, and equipped with ultrasonic generators (34), in order to constitute, thereby, an ultrasonic cleaning unit (29), said storing tank (28) comprising at least one draining pipe (36) issuing into said reservoir and controlled by a valve (40), and overflow means along one side of the tank on the boards inlet side, and in that it comprises a control device for the selective control of said spray-cleaning unit, of said ultrasonic cleaning unit and of said valve, so as to determine a first mode of operation in spray-cleaning in which said spray-cleaning unit is operative, said ultrasonic cleaning is stopped and said valve is open in order to allow a flow of solvent to drip towards said reservoir, and a second mode of ultrasonic cleaning operation in which said valve is closed, said ultrasonic cleaning unit is operative, this resulting in the tank being filled with a shallow solvent sheet in which the boards which are carried along said path are immersed, and in the solvent sheet flowing within said tank in a direction opposite to the moving direction of the printed circuit boards.

2. Apparatus according to claim 1, characterized in that it comprises at least two spray-cleaning units (22, 26), each unit being composed of spraying ramps situated over and under (22i, 22s, 26i, 26s) said path (18), one of said units (22) being situated above the tank (28) and the other (26) being situated outside the hold of the tank (28), said bottom of the tank comprising two draining pipes (36, 38) equipped with valves (40, 42) and issuing into two solvent reservoirs (46, 50).

3. Apparatus according to claim 2, characterized in that it comprises at least three-spray-cleaning units (22, 24, 26), two of which (22, 24) are situated above the tank (28) and the third outside (26) the tank, the bottom of said tank having the profile of two opposite gradients descending from a central zone situated between the first two units and the draining pipes (36, 38) are situated at the two ends of the tank and respectively communicate with two solvent reservoirs (46, 50).

4. Apparatus according to claim 3, characterized in that the third spray-cleaning unit (26) is a final rinsing unit supplied with pure solvent and situated immediately next to a side (32b) of the tank (28) on the boards outlet side, so that the sprayed solvent drips bark into the tank.

5. Apparatus according to anyone of claims 1 to 4, characterized in that said ultrasonic cleaning unit (2a) comprises ultrasonic transducers (74) mounted in closed casings (70, 72), said casings being fixed underneath the bottom (30) of the tank (28).

6. Apparatus according to claim 5, characterized in that it comprises blower means (80) for pressurizing the said casings (70, 72) with air, neutral gas or a mixture of neutral gases.

7. Apparatus according to claim 6, characterized in that the connection between the blower means (80) and the casings is achieved via a delivery pipe (82) between the blower and a first rasing, then between the successive casings via transfer pipes (84).

8. Apparatus according to claim 7, characterized in that the electric cable (86) suppling the transducers (74) is placed inside said delivery (82) and transfer (84) pipes.

9. Apparatus according to anyone of claims 1 to 8, characterized in that said side (32a) of the tank (28) on the inlet side is less high than the other side (32b) of the tank on the outlet side.

10. Apparatus according to anyone of claims 2 to 9, characterized in that said path (18) has a portion (18a) descending from an inlet aperture (14) of the enclosure (12) to the horizontal portion (18b), as well as a portion (18c) rising from the horizontal portion (18b) to an outlet aperture (16) of said enclosure (12).

11. Apparatus according to claim 4, characterized in that it comprises also a prewashing spray unit (20) situated ahead and apart from the adjacent side (32a) of said tank (28), so that the sprayed solvent drips back towards the base of the enclosure.

## Patentansprüche

1. Reinigungsvorrichtung (10), insbesondere für Leiterplatten, umfassend eine Umhüllung (12), die von einer, die Leiterplatten entlang einer durchgehenden Bahn (18) bewegenden Fördervorrichtung durchquert wird, mit zumindest einer Station (22) zur Reinigung mittels eines Lösungsmittels, das so bewegt wird, daß die Platten, während sie sich entlang der Bahn bewegen auf der Ober- und Unterseite angesprizt werden, mit zumindest einem Behälter für das Lösungsmittel, der unterhalb der Umhüllung angeordnet ist und der dazu bestimmt ist, das Lösungsmittel, das nach dem Versprühtwerden zusammenläuft, zu sammeln, und mit einem Trog, der dazu bestimmt ist, Lösungsmittel aufzunehmen, der von einem Abschnitt der Bahn durchquert wird, dadurch gekennzeichnet, daß der Trog aus einem Trog (28) mit geringer Tiefe des in der Umhüllung (12) bewegten Lösungsmittels besteht, daß er parallel zu einem horizontalen Abschnitt (18b) der Bahn und in geringem Abschnitt unter ihr und über dem Behälter vorgesehen ist, daß er mit Ultraschallquellen (34) ausgerüstet ist, um auch eine Ultraschallreinigungsstation (29) zu bilden, und daß der Trog (28) zumindest eine Abflußleitung (36), die zum Lösungsmittelbehälter führt, mit einem Ventil (40) aufweist, und daß eine Abflußmöglichkeit entlang der Seite des Troges, an der die Platten eingebracht werden, besteht, und daß eine Befehlsvorrichtung vorgesehen ist, die dazu bestimmt ist, selektiv die Sprühreinigungsstation, die Ultraschallreinigungsstation und das Ventil so zu aktivieren, daß eine erste Reinigungsart durch Sprühen bewirkt wird, bei der die Sprühreinigungsstation aktiv, die Ultraschallreinigungsstation inaktiv und das Ventil geöffnet ist, um den Abfluß des Lösungsmittels zum Behälter zu erlauben, oder so, daß eine zweite Reinigungsart durch Ultraschall bewirkt wird, bei der das Ventil geschlossen und die Ultraschallreinigungsstation aktiv ist, wodurch der Trog mit einer Lösungsmittelschicht geringer Höhe gefüllt ist, in die die entlang der Bahn bewegten Platten eintauchen, wobei sich die Lösungsmittelschichte im Trog im Gegensinn zur Bewegung der Platten bewegt.

2. Vorrichtung nach Anspruch 1, dadurch gekennzeichnet, daß sie zumindest zwei Sprühreinigungsstationen (22, 26) aufweist, von denen jede aus Sprühreihen besteht, die oberhalb und unterhalb (22i, 22s, 26i, 26s) der Bahn (18) angeordnet sind, besteht, wobei eine der Gruppen (22) oberhalb des Troges (28) und die andere (26) ausserhalb des Erfassungsgebietes des Troges (28) angeordnet ist, wobei der Trogboden zwei Ablaßleitungen (36, 38) aufweist, die mit Ventilen (40, 42) versehen sind, die zu zwei Lösungsmittelbehältern (46, 50) führen.

3. Vorrichtung nach Aspruch 2, dadurch gekennzeichnet, daß zumindest drei Sprühreinigungsstationen (22, 24, 26) vorgesehen sind, von denen zwei (22, 24) oberhalb des Troges (28) und die dritte (26) außerhalb des Troges angeordnet sind, wobei der Trogboden so profiliert ist, daß er zwei schräge Flächen aufweist, die von einer zentralen Zone, die zwischen den beiden ersten Stationen und den beiden, an den Enden des Troges angeordneten, Abflußleitungen (36, 38), die mit zwei Lösungsmittelbehältern (46, 50) kommunizieren, liegt, nach der Seite abfallen.

4. Vorrichtung nach Anspruch 3, dadurch gekennzeichnet, daß die dritte Sprühreinigungsstation (26) eine Endreinigungsstelle ist, die mit reinem Lösungsmittel versorgt wird, und die unmittelbar einem Rand (32b) des Troges (28) auf der Auslaßseite der Platten so benachbart ist, daß das zerstäubte Lösungsmittel in den Trog fällt.

5. Vorrichtung nach einem der Ansprüche 1 bis 4, dadurch gekennzeichnet, daß die Ultraschallreinigungsstation (2a) Ultraschallquellen (74) aufweist, die in geschlossenen Gehäusen (70, 72) montiert sind, die ihrerseits an der Unterseite des Bodens (30) des Troges (28) befestigt sind.

6. Vorrichtung nach Anspruch 5, dadurch gekennzeichnet, daß ein Ventilator (80) vorgesehen ist, der die Gehäuse (70, 72) mittels Luft, Inertgas oder einer Inertgasmischung unter Druck setzt.

7. Vorrichtung nach Anspruch 6, dadurch gekennzeichnet, daß die Verbindung zwischen dem Ventilator (80) und den Gehäusen über eine Förderleitung (82) zwischen dem Ventilator und einem ersten Gehäuse und sodann zwischen aufeinanderfolgenden Gehäusen durch Verbindungsleitungen (84) erfolgt.

8. Vorrichtung nach Anspruch 7, dadurch gekennzeichnet, daß das elektrische Versorgungskabel (86) der Ultraschallquellen (74) in der Förderleitung (82) und den Verbindungsleitungen (84) verläuft.

9. Vorrichtung nach einem der Ansprüche 1 bis 8, dadurch gekennzeichnet, daß der Rand (32a) des Troges (28) auf der Eingangsseite eine niedrigere Höhe aufweist, als der Rand (32b) auf der Ausgangsseite.

10. Vorrichtung nach einem der Ansprüche 2 bis 9, dadurch gekennzeichnet, daß die Bahn (18) von einer Eingangsöffnung (14) der Umhüllung (12) aus, einen abfallenden Abschnitt (18a), sodann einen horizontalen Abschnitt (18b) und schließlich, ausgehend vom horizontalem Abschnitt (18b), einen ansteigenden Abschnitt (18c) bis zu einer Ausgangsöffnung (16) der Umhüllung (12) umfaßt.

11. Vorrichtung nach Anspruch 4, dadurch gekennzeichnet, daß sie weiters eine Vorwaschstation (20) umfaßt, die als Sprühstation ausgebildet ist und die im Abstand vor dem Rand (32a) und nahe des Troges (28) so angeordnet ist, daß das versprühte Lösungsmittel auf den Boden der Umhüllung fällt.

Fig.1

Fig. 2

Fig.3